# EUROPEAN PATENT APPLICATION

(11) **EP 2 833 390 A1**
(43) Date of publication of application: **04.02.2015**
(21) Application number: 13179026.3
(22) Date of filing: 02.08.2013
(51) Int. Cl.: H01J 37/145, H01J 37/12, H01J 37/28

(54) **Use of electrostatic objective lens in an electron microscope**

(71) Applicant: FEI COMPANY, Hillsboro, Oregon 97124-5793 (US)
(72) Inventor: Tuma, Lubomír, 62800 Brno (CZ); Sytar, Petr, Brno (CZ); Skalicky, Jan, 61500 Brno (CZ)
(74) Representative: Bakker, Hendrik

(57) **Abstract**

The invention relates to the use of a scanning electron microscope column equipped with a electron source for producing a beam (100) of electrons, an electrostatic immersion objective lens for focusing the beam on a sample (102), and a detector (116) at the source side of the objective lens for detecting electrons emerging from the sample, the detector showing a hole for passing the beam, the detector at least partly surrounding the beam, the lens equipped with a first electrode (110) through which the beam enters the lens; and a second electrode (106) through which the beam leaves the lens, the first electrode and the detector electrically biased with respect to the second electrode, the objective lens showing an angular magnification M_{α} for electrons emerging from the sample, a first part of the electrons travelling to the detector passing through the hole of the detector and a second part of the electrons travelling to the detector intercepted by the detector.
Such a lens tends to show a low detection efficiency near the axis. Inventors found that, by applying a moderate positive bias to the sample, this could be remedied.

## Description

The invention relates to use of a charged particle column, the column equipped with
- a charged particle source for producing a beam of charged particles,
- an electrostatic immersion objective lens for focusing the beam of charged particles on a sample, and
- a detector at the source side of the objective lens for detecting electrons emerging from the sample, the detector showing a hole for passing the beam of charged particles, the detector at least partly surrounding the beam of charged particles,
   the lens equipped with
- a first electrode through which the beam of charged particles primary electrons enters the lens and
- a second electrode through which the beam of charged particles leaves the lens, the first electrode and the detector electrically biased with respect to the second electrode, the objective lens showing an angular magnification M_{α} for electrons emerging from the sample,
   a first part of the ions or electrons emerging from the sample travelling to the detector passing through the hole of the detector and a second part travelling to the detector intercepted by the detector,

Such a charged particle column is known from European patent application publication No. EP2518755.

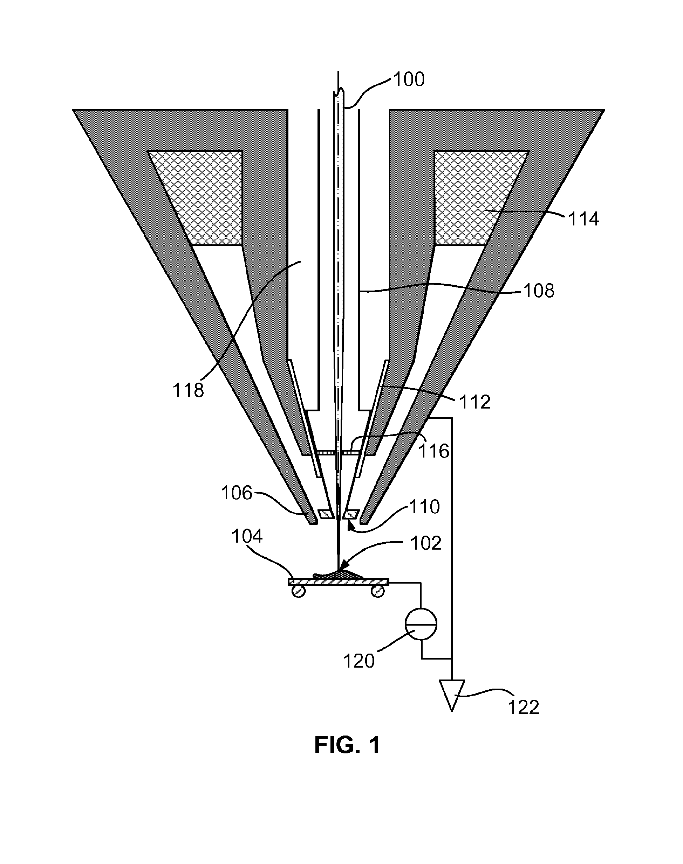

In this application a compound lens is shown in which a beam of charged particles (electrons) is focused by cooperating magnetic and electrostatic fields. In its figure 1 a detector 116 is shown for detecting electrons emerging from the sample. Part of the electrons, more specifically electrons emerging from the sample in a direction and position close to the axis, do not impinge on the detector, but will pass through the detector.

When imaging a sample at low magnification this results in a central darkening as at the center of the image more electrons will emerge with a direction and position close to the axis.

At high magnification of a part of the sample close to the axis this results in low collection efficiency.

There is a need to remedy these disadvantages by offering higher collection efficiency at high magnification and a more uniform collection efficiency at low magnification.

It is an object of the invention to provide such a remedy.

To that end the method according to the invention is **characterized in that** the sample is electrically positively biased with respect to the second electrode so that the angular magnification M_{α} is increased to such an extent that less than 25% of the electrons pass through the hole, preferably less than 10%.

The invention is based on the insight that the detector mainly detects secondary electrons (SE's). Secondary electrons are commonly defined as electrons emerging from the sample with an energy of less than 50 eV. These SE's are then accelerated to the first electrode. After that the SE's either impinge on the detector, or pass through the hole in the detector and are lost for imaging. The detection efficiency is largely influenced by the size of the hole and the angular magnification of electrons emerging from the sample. The hole size is dictated by the requirement that the beam of charged particles should pass through it in deflected and undeflected condition. At a low angular magnification many of the secondary electrons pass through the hole, while at high angular magnification less electrons pass through the hole.

Inventors found that by biasing the sample with respect to the second electrode the angular magnification of the objective lens as seen by the secondary electrons can be changed (increased).

By increasing the angular magnification to such an extent that less than 25%, more preferably less than 10% of the electrons travel through the hole in the detector and are lost for detection, higher collection efficiency at high magnification and more uniform collection efficiency at low magnification is achieved.

It is noted that typically the particles emerging from the sample are electrons, and the bias of the first electrode and the detector with respect to the second electrode is a positive bias. However, in the case where positively charged ions are to be detected, as known to the skilled artisan a proper ion detector can be used (often involving the conversion from ions to electrons) with biases of the other polarity (negative polarity with respect to the second electrode).

Although the prior art lens is a compound lens, employing both a magnetic field and an electrostatic field, the invention can be used for a purely electrostatic configuration as well.

A compound magnetic/electrostatic immersion lens, or better yet a compound lens in which both the magnetic and the electrostatic fields extend to the sample (both fields thus immersion fields) shows better lens performance than an electrostatic lens without an additional magnetic field.

In a preferred embodiment the detector is at the same potential as the first electrode.

Mounting the detector in a part of a tube connected to the first electrode, and having the detector and the tube at the same potential, results in a simple design.

In another embodiment the first electrode is biased with a voltage of more than 3 kV with respect to the second electrode.

This embodiment is especially useful when using a beam of electrons: the electrons are then decelerated by the immersion field, resulting in lower lens aberrations than when no retarding field is present.

In yet another embodiment which the sample is biased to a voltage of less than 600 V with respect to the second electrode.

Experiments showed that, with a bias of 8 kV on the first electrode, a bias of less than 600 V suffices to increase the detector efficiency at high magnification and offer a more uniform collection efficiency at low magnification.

In a preferred embodiment of the invention the beam of charged particles is a beam of electrons.

Although the invention can be used with a beam of positively charged particles, such as ions, positively charged molecules etc, the invention is particularly effective with a lens used for focusing a beam of negatively charged particles, more specifically electrons.

The beam of electrons may impinge on the sample with a selectable energy of between 50 eV and 30 keV or more.

The invention is now elucidated using figures, where identical numerals refer to corresponding features.

To that end:
Figure 1 schematically shows a compound lens with a detector;
Figure 2 shows an image acquired without sample bias; and
Figure 3 shows an image acquired with stage bias.

Figure 1 schematically shows a beam of charged particles 100 impinging on a sample 102. The sample is mounted on a sample carrier 104 that is movable with respect to the beam. The objective lens comprises a magnetic yoke with two pole pieces guiding the magnetic field generated with coil 114 to an area near the beam. The yoke is connected to ground, and also forms the second electrode 106. The first electrode 110 is a disk connected to a tube surrounding the beam. Insulator 112 centers the tube within the magnetic yoke and electrically insulates the two.

It is noted that the tube and the face need not be one piece, or even made of one material.

An electron detector 116 is located in an electrically field free region within the tube connected to the first electrode. This detector may, for example, be a solid state electron detector, or a detector comprising a scintillator and photon detector.
It is noted that magnetic deflectors can be placed in, for example, area 118 between the inner yoke and the tube connected to the first electrode.

A voltage source 120 enables biasing of the sample with respect to the second electrode. Here the reference of the voltage source and the second electrode are connected to ground 122, but another common potential can be used.

It is noted that, as this lens uses both a magnetic and an electrostatic field for focusing the charged particles, this lens is less effective for ions than for electrons, as ions - due to their large mass- are less susceptible to the effect of a magnetic field than electrons. The working of this embodiment is therefore further explained with (negatively charged) electrons.

The objective lens is a combined electrostatic and magnetic lens. For practical reasons the magnetic yoke with the coil 114, and thus electrode 106, is normally connected to ground , but this is not a fundamental limitation.

The primary electrons, when impinging on the sample, cause the emission of secondary radiation, including backscattered electrons (BSEs) and secondary electrons (SEs). From a detection point of view the difference between these two is that an SE is often defined as an electron emerging from the sample with an energy of less than 50 eV, or even less than 5 eV, while a BSE emerges from the sample with an energy above 50 eV (up to the energy of the primary beam). The electric field between the sample and the second electrode directs both these electrons towards the direction of the first electrode 110, and let them enter the magnetic field breaking out of the lens. The low energy electrons (all SEs and a small part of the BSEs) are kept so close to the axis that they travel through the hole in face 110 and enter the field free region within the second electrode. Part of these electrons then hit detector 116, but, depending on the position where the electrons left the sample, another part pass through the hole of the detector and is lost for imaging.

It is noted that a compound lens can have additional coils for producing an imeersion magnetic field at the sample as well.

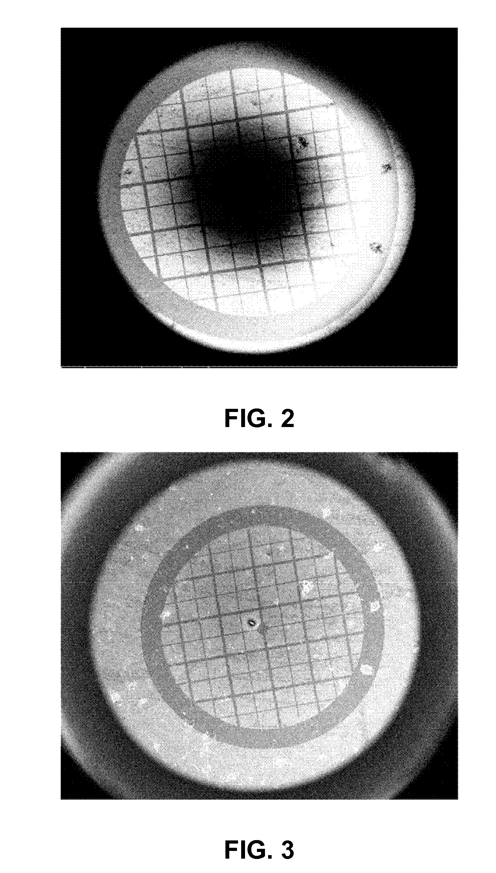

Figure 2 and figure 3 use the lens settings, with the exception of the sample voltage (with respect to the second electrode). These conditions are: working distance (lens - sample distance) 10 mm, landing energy 1 keV, voltage of the first electrode 8 kV and second electrode grounded.

Figure 2 shows the effect of the low collection efficiency when the sample is not biased. The landing energy of the electrons is 1 keV, and the voltage of the first electrode is 8 kV (the second electrode is grounded, as is the sample). It is noted that, at high magnification the collection efficiency will become constant over the field of view, but at a low signal level and thus a low signal-to-noise level.

Figure 3 shows the effect of the higher collection efficiency at a sample bias of 360 V.

It is noted that it is possible to invert all voltages and use a beam of positively charged ions while detecting ions. Ion detectors, often converting ions to electrons and then detecting the thus formed electrons, are known to the person skilled in the art.

It is further noted that the lens may be an electrostatic immersion lens, a compound lens having an electrostatic immersion field and a non-immersion magnetic field, or a compound lens having an electrostatic immersion field and a magnetic immersion field. In the latter case the lens may use different coils for the magnetic immersion field and a magnetic non-immersion field, as known from European Patent Application No. EP12183662.

## Claims

1. Use of a charged particle column, the column equipped with
• a charged particle source for producing a beam (100) of charged particles,
• an electrostatic immersion objective lens for focusing the beam of charged particles on a sample (102), and
• a detector (116) at the source side of the objective lens for detecting electrons or ions emerging from the sample, the detector showing a hole for passing the beam of charged particles, the detector at least partly surrounding the beam of charged particles,
the lens equipped with
• a first electrode (110) through which the beam of charged particles enters the lens; and
• a second electrode (106) through which the beam of charged particles leaves the lens,
the first electrode electrically biased with respect to the second electrode and the detector electrically biased with respect to the second electrode,
the objective lens showing an angular magnification M_{α} for electrons emerging from the sample,
a first part of the ions or electrons emerging from the sample travelling to the detector passing through the hole of the detector and a second part travelling to the detector intercepted by the detector,
**characterized in that**
the sample is electrically positively biased with respect to the second electrode so that the angular magnification M_{α} is increased to such an extent that less than 25% of the electrons pass through the hole of the detector, preferably less than 10% of the electrons pass through the hole of the detector.

2. Use of the charged particle column of claim 1 in which the detector is an electron detector, the first electrode and the detector are positively biased with respect to the second electrode.

3. Use of the charged particle column of claim 1 or claim 2 in which the objective lens is a compound objective lens using an additional magnetic field for focusing the beam (100) of charged particles.

4. Use of the charged particle column of any of the preceding claims in which the detector (116) is at the same potential as the first electrode (110).

5. Use of the charged particle column of any of the preceding claims in which the first electrode (110) is biased with a voltage of more than 3 kV with respect to the second electrode (106).

6. Use of the charged particle column of any of the preceding claims in which the sample (102) is biased to a voltage of less than 600 V with respect to the second electrode (106).

7. Use of the charged particle column of any of the preceding claims in which the beam (100) of charged particles is a beam of electrons.

8. Use of the charged particle column of any of the preceding claims in which the beam of charged particles (100) impinge on the sample (102) with an energy of at least 50 eV.
